# EUROPÄISCHE PATENTSCHRIFT

(11) **EP 2 510 412 B1**
(45) Veröffentlichungstag und Bekanntmachung des Hinweises auf die Patenterteilung: **09.04.2014**
(21) Anmeldenummer: 10781445.1
(22) Anmeldetag: 24.11.2010
(51) Int. Cl.: G05B 19/418, H05K 7/14

(54) **ELEKTRONISCHE BAUGRUPPE**
ELECTRONIC ASSEMBLY
MODULE ÉLECTRONIQUE

(30) Priorität: 08.12.2009 DE 102009057273
(43) Veröffentlichungstag der Anmeldung: 17.10.2012
(73) Patentinhaber: Diehl BGT Defence GmbH & Co. KG, 88662 Überlingen (DE)
(72) Erfinder: KISAKÜREK, Hakan, 81476 München (DE)
(74) Vertreter: Diehl Patentabteilung
(86) Internationale Anmeldenummer: PCT/EP2010/007117
(87) Internationale Veröffentlichungsnummer: WO 2011/069602

(56) Entgegenhaltungen:
- EP-A2- 1 120 695
- DE-A1- 19 539 354
- US-A1- 2009 043 937
- US-B1- 6 778 389

## Beschreibung

Die Erfindung betrifft eine elektronische Baugruppe mit mehreren Funktionseinheiten, die jeweils ein mit elektronischen Bausteinen bestücktes Plattenelement umfassen, wobei die Plattenelemente über eine Kontaktplatte signaltechnisch miteinander verbunden sind. Die elektronische Baugruppe ist eine Steuereinheit zur eigenständigen Steuerung eines Flugkörpers.

Elektronische Baugruppen zur Steuerung komplexer Vorgänge umfassen üblicherweise mehrere Funktionseinheiten auf jeweils einer Platine, denen unterschiedliche Funktionen bzw. Aufgaben zugewiesen sind. Die komplexe Steuerungsaufgabe wird hierbei durch ein Zusammenwirken der die verschiedenen Teilaufgaben bearbeitenden Funktionseinheiten gelöst.

Die mechanische und signaltechnische Verbindung der einzelnen Funktionseinheiten wird üblicherweise über eine sogenannte Backplane realisiert, die auch Busplatine oder Rückplatte genannt wird. Eine solche Backplane umfasst für jede Funktionseinheit einen Steckplatz, durch die die Funktionseinheiten mechanisch und signaltechnisch fest mit der Backplane verbunden sind. Die einzelnen Steckplätze sind je entsprechend der Aufgabe der elektronischen Baugruppe und der einzelnen Teilaufgaben der Funktionseinheiten miteinander verdrahtet, sodass die Funktionseinheiten miteinander kommunizieren und ihre Teilaufgaben durch Datenaustausch untereinander lösen können. Die durch die Backplane zwischen den Steckplätzen hergestellten elektrischen Verbindungen können sehr unterschiedlich sein und bestimmen die Architektur der Backplane und der elektronischen Baugruppe.

Durch die aufgabenspezifische Verdrahtung sind Backplanes ein zentraler Bestandteil von integrierten, rechnergesteuerten Systemen, vor allem der Telekommunikation, der Mess- und Automatisierungstechnik, der Medizintechnik oder Luftfahrt und

Bahntechnik. Als zentrales Element bildet die Backplane eine Bus-Architektur zur Verbindung der einzelnen Pins der Steckplätze und damit der einzelnen Kontaktstellen aller Funktionseinheiten.

Aus der KR 20030094464 A ist ein Routing-System bekannt, dessen Anzahl an Leitungsschnittstellen durch Sub-Schaltfähigkeit der beinhalteten Leitungsschnittstellen-Module erhöht ist. Ein solches Modul umfasst eine Sub-Schaltkarte mit einem Sub-Schalter und mit Schalt-Eingangs- und Schalt-Ausgangspuffer und eine Backplane. Über die Backplane wird eine Verbindung zwischen den Leiterkarten und der Sub-Schaltkarte hergestellt.

Es ist eine Aufgabe der Erfindung, eine Steuereinheit zur eigenständigen Steuerung eines Flugkörpers anzugeben, die ein hohes Maß an Kommunikationsflexibilität verbunden mit günstigen Herstellungskosten aufweist.

Diese Aufgabe wird durch eine Steuereinheit gemäß den Merkmalen von Patentanspruch 1 gelöst.

Die Erfindung geht hierbei von der Überlegung aus, dass zumindest einzelne der Funktionseinheiten mit Systemen außerhalb der elektronischen Baugruppe kommunizieren, um eine Steuerung zu bewirken oder Sensor- oder Steuersignale empfangen zu können. Hierzu sind die einzelnen Funktionseinheiten entsprechend ihrer Aufgaben zur Kommunikation nach außen vorbereitet, sodass sie in Bezug zu einer benötigten Datenübertragungsrate, Datenform und/oder einem Übertragungsprotokoll mit entsprechenden Einstellungen versehen sind. Werden mehrere ähnliche Baugruppen zur Bewältigung ähnlicher Aufgaben bei ähnlichen Steuerprozessen hergestellt, so ist es vorteilhaft, wenn die unterschiedlichen Baugruppen zumindest hinsichtlich ihrer Funktionseinheiten identisch ausgeführt sein können, um eine Fertigung zu vereinfachen. Dieser Vereinfachung steht die notwendige Kommunikationsanpassung der einzelnen Funktionseinheiten an externe Steuereinheiten, Aktuatoren oder Sensoren im Wege. Da eine solche Kommunikationsanpassung in der Regel für mehrere Funktionseinheiten einer elektronischen Baugruppe notwendig ist, ist es besonders sinnvoll, sie zu zentralisieren. Als zentrale Funktionseinheit bietet sich hierbei eine Backplane an, die eine zentrale Funktionseinheit der Baugruppe darstellt.

Die Erfindung geht von der weiteren Überlegung aus, dass eine weitere Standardisierung ähnlicher Baugruppen durch einen noch weitergehenderen modularen Aufbau erreichbar ist, durch den unterschiedliche Funktionen verschiedenen Baueinheiten zugewiesen wird. In dieser Hinsicht ist eine funktionale Trennung von Kommunikationsanpassung und aufgabenspezifischer Verdrahtung der Backplane vorteilhaft. Diese Trennung kann vollzogen werden, wenn die aufgabenspezifische Verdrahtung der Funktionseinheiten von einem ersten Teil der Backplane und die Kommunikationsanpassung von einem zweiten Teil der Backplane vorgenommen wird. Hierbei müssen nicht beide Teile die weiteren üblichen Aufgaben einer Backplane, wie das mechanische Verbinden der Funktionseinheiten, übernehmen. Diese modulare Trennung kann durch die die Trennung der Backplane in eine Kontaktplatte und eine Kommunikationseinheit vollzogen werden. Die Kommunikationseinheit und die Kontaktplatte können getrennt voneinander hergestellt und somit auch getrennt voneinander konfiguriert werden.

Die Plattenelemente können Platinen sein, die über die Kontaktplatte auch mechanisch miteinander verbunden sind. Ein Baustein kann ein Prozessor sein oder einen oder mehrere elektronische Bauelemente umfassen. Zweckmäßigerweise bildet die Kommunikationseinheit ein eigenes Plattenelement, das von der Kontaktplatte separat in der elektronischen Baugruppe gehaltert ist. Hierbei ist es vorteilhaft, wenn die Kommunikationseinheit mechanisch separat von der Kontaktplatte in beispielsweise einem Gehäuse gehaltert ist.

Die Kommunikationseinheit entsprechend der Erfindung ist so ausgeführt, dass sie eine informationsverbindende Kommunikationsschnittstelle zwischen zumindest einem internen Kommunikationsmodus einer Funktionseinheit mit einem davon unterschiedlichen externen Kommunikationsmodus einer Einheit außerhalb der elektronischen Baugruppe bildet. Als Kommunikationsschnittstelle wird eine Einheit angesehen, die zum Anpassen zweier unterschiedlicher Kommunikationsmodi aneinander vorgesehen ist. Die Unterschiedlichkeit kann in unterschiedlichen Kommunikationsprotokollen, Datenübergabeprotokollen, Kommunikationsdatenraten, Signalamplituden und dergleichen liegen. Die externe Einheit kann eine externe Steuereinheit, Sensoren, Aktuatoren oder dergleichen sein. Zusätzlich kann die Kommunikationseinheit eine Kommunikationsschnittstelle zwischen einem internen Kommunikationsmodus einer Funktionseinheit und einem unterschiedlichen Kommunikationsmodus einer weiteren Funktionseinheit der elektronischen Baugruppe sein.

Es ist außerdem vorteilhaft, wenn eine durch die Datenleitungen hergestellte Datenverbindung zwischen den Funktionseinheiten und der Kommunikationseinheit zumindest einen Highspeedbus bilden. Gegebenenfalls kann es ausreichend sein, wenn nur die interne Verbindung zwischen den Funktionseinheiten, und damit Datenleitungen in der Kontaktplatte, als Highspeedbus ausgeführt sind. Als ein Highspeedbus kann im Folgenden eine Busverbindung mit einer Datenrate von zumindest 1 Mbit/s verstanden werden.

Das Modularitätsprinzip kann weiter gefördert werden, wenn die Kontaktplatte passiv ist und die Kommunikationseinheit aktiv. Unter Aktivität wird in diesem Zusammenhang die Bestückung mit aktiven Bauelementen, wie ICs oder passiven Bauelementen, wie Widerständen oder Kondensatoren verstanden. Dementsprechend ist die Kontaktplatte passiv, wenn sie keine aktiven oder passiven Bauelemente trägt, sondern lediglich mit z.B. Datenleitungen versehen ist, in denen die Daten bzw. Signale insbesondere ohne jede Datenverarbeitung von einem Eingangskontakt zu einem Ausgangskontakt geführt werden.

Durch die Zentralisierung der Kommunikationsanpassung der Funktionseinheiten untereinander und der Funktionseinheiten nach außen, also zu Einheiten außerhalb der elektronischen Baugruppe, können die Funktionseinheiten standardisiert werden. Sie sind daher zweckmäßigerweise in ihrer Hardware alle identisch ausgeführt. Durch unterschiedliche Datenverarbeitungsprogramme, wie beispielsweise Firmware und/oder weitere frei programmierbare Software können die Funktionseinheiten auf ihre unterschiedlichen Aufgaben ausgerichtet werden.

Durch den modularen Aufbau der Backplane kann die elektronische Baugruppe besonders einfach an unterschiedliche Aufgaben angepasst werden, indem beispielsweise nur eine Baueinheit, wie die Kommunikationseinheit und/oder die Kontaktplatte, and die Aufgabe angepasst wird. Bei einem System aus beispielsweise einer ersten elektronischen Baugruppe für eine erste Aufgabe und einer zweiten elektronischen Baugruppe für eine unterschiedliche zweite Aufgabe können somit die Funktionseinheiten der ersten Baugruppe in ihrer Hardware identisch sein wie die Funktionseinheiten der zweiten Baugruppe. Es kann ausreichend sein, wenn nur die beiden Kommunikationseinheiten in ihrer Hardware verschieden und jeweils an die entsprechende Aufgabe angepasst sind, gegebenenfalls sogar bei identischen Kontaktplatten. Bei weitgehend verschiedenen Aufgaben der beiden Baugruppen ist es auch möglich, dass die Kontaktplatten unterschiedlich sind, beispielsweise in der Art, dass die Funktionseinheiten der beiden Baugruppen durch die beiden Kontaktplatten unterschiedlich verdrahtet sind.

Die Kontaktplatte weist vorteilhafterweise eine an einzelne Aufgaben der Funktionseinheiten angepasste aufgabenspezifische Leitungsführung auf, die von einer zu einer zweiten Funktionseinheit anders ausgeführt ist, als von der zweiten zu einer dritten Funktionseinheit. Insbesondere können die Leitungsführungen zwischen allen Funktionseinheiten jeweils unterschiedlich sein.

In einer weiteren vorteilhaften Ausführungsform der Erfindung ist eines der elektronischen Bauelemente der Kommunikationseinheit ein Router. Hierdurch kann die Kommunikation zwischen Funktionseinheiten der elektronischen Baugruppe und/oder einer Funktionseinheit und einer externen Einheit zentralisiert werden. Eine spezielle an Kommunikationsaufgaben angepasste Kommunikationsverdrahtung ist somit unter Umständen nicht mehr nötig, sondern kann durch eine entsprechende Programmierung des Routers ersetzt werden. Hierdurch kann die Herstellung der elektronischen Baugruppe vereinfacht und die Flexibilität der Kommunikation erhöht werden. Der Router ist vorteilhafterweise als Non-Blocking-Router ausgeführt, er besitzt also eine verfügbare Datenverarbeitungsrate, die höher als der maximal mögliche Datenverkehr ist, die er zu bewältigen hat. Jedem Port einer jeden Funktionseinheit kann hierdurch jederzeit die für ihn volle Datenübertragungsrate zur Verfügung gestellt werden.

Außerdem wird vorgeschlagen, dass der Router zur Protokollierung von Kommunikation zwischen elektronischen Bausteinen der Plattenelemente ausgeführt ist. Hierdurch kann auf eine Weise durch Datenabfrage vom Router ein Debugging der elektronischen Baugruppe durchgeführt werden.

Eine weitere vorteilhafte Ausgestaltung der Erfindung sieht vor, dass die Kommunikationseinheit eine Stromversorgung für die Funktionseinheiten aufweist. Auch hierdurch kann eine vorteilhafte modulare und insbesondere kompakte Bauweise der elektronischen Baugruppe erfolgen. Vorteilhafterweise ist die Stromversorgung derart ausgeführt, dass sie eine Zwischenspannung herstellt, die zwischen einer von außen zugeführten Spannung und einer von Bausteinen der Funktionseinheiten benötigten Spannung liegt. So kann beispielsweise eine interne Versorgungsspannung von 3,3 Volt fehlerunanfällig über die Übertragungsdistanzen der elektronischen Baugruppe übertragen werden, wobei mit einer Spannung von 5 Volt, 12 Volt oder höher aus einem externen Stromversorgungsnetz gearbeitet werden kann.

Weitere Vorteile der standardisierten Modulbauweise können erzielt werden, wenn die Kommunikationseinheit zur Steuerung einer Einschaltsequenzierung der einzelnen Funktionseinheiten vorbereitet ist. Hierdurch kann auf eine Veranlassung der Einschaltsequenzierung durch die Funktionseinheiten selbst verzichtet werden, die hierdurch in Hardware und Software vereinfacht und damit leichter standardisierbar herstellbar sind.

Ist die Kommunikationseinheit mit einer Test-Schnittstelle zur Funktionsprüfung der einzelnen Funktionseinheiten versehen, so kann auf einfache Weise ein Debugging von außen, insbesondere während des Betriebs der elektronischen Funktionseinheit durchgeführt werden, ohne dass jede Funktionseinheit einer solchen Schnittstelle extra bedarf. Durch die Funktionsprüfung kann zweckmäßigerweise jede Funktionseinheit einzeln geprüft werden.

Die Erfindung ist außerdem gerichtet auf ein Verfahren zum Betrieb einer wie oben beschriebenen Steuereinheit zur eigenständigen Steuerung eines Flugkörpers. Es wird vorgeschlagen, dass erfindungsgemäß eines der elektronischen Bauelemente ein Router ist. Es kann hierdurch eine Fehlererfassung an zentraler Stelle durchgeführt werden. Der Router protokolliert insbesondere eine Kommunikation von zumindest einer Funktionseinheit. Eine Funktionsüberprüfung der Funktionseinheiten und/oder der Bausteine wird zweckmäßigerweise während des regulären Betriebs der Baugruppe durchgeführt.

Die Funktionsüberprüfung und insbesondere das Beheben eines Fehlers durch eine entsprechende Programmierung des Routers kann von außen, also von außerhalb der elektronischen Baugruppe getriggert werden, beispielsweise durch eine Steuereinheit mit einer entsprechenden Überprüfungsfunktion. Zur Funktionsüberprüfung können Kommunikationsdaten mit Solldaten zur Kommunikation durch den Router verglichen werden.

Eine Funktionsüberprüfung kann vereinfacht werden, wenn Kommunikationsdaten zum Anzeigen von Kommunikationsprozessen visualisiert werden. Die Visualisierung geschieht zweckmäßigerweise auf einem Bildschirm, insbesondere anhand einer grafischen Darstellung. Die Funktionsüberprüfung kann durch eine externe Anfrage und/oder auf Initiative des Routers getriggert werden, beispielsweise wenn ein routinemäßiger Protokolldatenvergleich einen Kommunikationsfehler nahegelegt.

Durch die Abfrage des Routers kann das funktionale Innenleben der Baugruppe überprüft und insbesondere sichtbar gemacht werden.

Weitere Vorteile ergeben sich aus der folgenden Zeichnungsbeschreibung. In der Zeichnung sind Ausführungsbeispiele der Erfindung dargestellt. Die Zeichnung und die Beschreibung enthalten zahlreiche Merkmale in Kombination, die der Fachmann zweckmäßigerweise auch einzeln betrachten und zu sinnvollen weiteren Kombinationen zusammenfassen wird.

Es zeigen:
- Fig. 1: Ein Schaltbild einer elektronischen Baugruppe mit mehreren Funktionseinheiten, einer Kontaktplatte und einer Kommunikationseinheit,
- Fig. 2: eine alternative elektronische Baugruppe mit einem Router auf der Kommunikationseinheit,
- Fig. 3: eine schematische perspektivische Außenansicht auf die elektronische Baugruppe,
- Fig. 4: eine Ansicht auf eine der Funktionseinheiten der elektronischen Baugruppe in einem Gehäuse und
- Fig. 5: eine Ansicht in das Gehäuse ohne die Baueinheit.

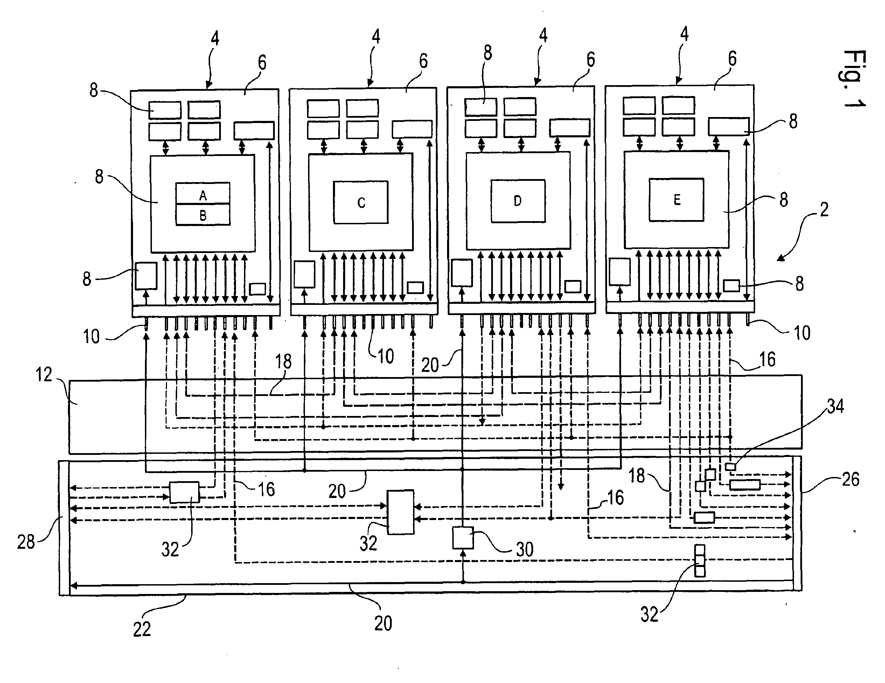

Fig. 1 zeigt einen schematischen Schaltplan einer elektronischen Baugruppe 2 mit vier Funktionsgruppen 4, die jeweils ein Plattenelement 6 in Form einer Platine und darauf angeordnete elektronische Bausteine 8 umfasst. Die elektronische Baugruppe 2 dient zur Steuerung eines Lenkflugkörpers und zur Auswertung von Signalen eines Suchkopfs. Als Baustein 8 können ein oder mehrere elektronische Bauelemente verstanden werden, die einzeln oder gemeinsam eine Funktion erfüllen. Bei einer jeden dieser Funktionsgruppen 4 ist einer der Bausteine 8 ein zentraler Prozessor, der mit Software, also einem oder mehreren elektronischen Datenverarbeitungsprogrammen, beispielsweise in Form von Firmware und zusätzlicher frei programmierbarer Software, ausgerüstet ist. Hierdurch ist jeder Prozessor in der Lage, einen Aufgabenbereich oder eine Funktion zu bearbeiten, wobei die Funktionen der Prozessoren verschieden sind und in Fig. 1 symbolisch mit den Buchstaben A bis E angedeutet sind. Abgesehen von der unterschiedlichen Programmierung sind die Funktionsgruppen 4 in Bezug auf ihre Hardware, also ihre elektronischen Bausteine 8 und deren Verdrahtung, also die Leitungsführung untereinander und nach außen, vollkommen identisch ausgeführt und sind auch sonst identisch.

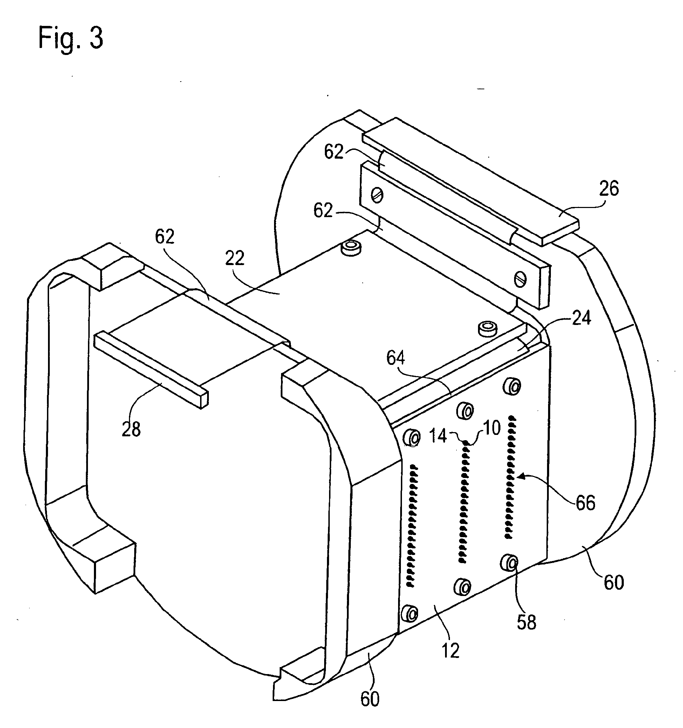

Jedes der Plattenelemente 6 trägt eine Anzahl von Kontaktstellen 10 in Form von Pins, durch die die Funktionsgruppen 4 signaltechnisch und zur Stromversorgung sowie auch mechanisch mit einer Kontaktplatte 12 verbunden sind. Hierzu sind die Kontaktstellen 10 in entsprechende Kontaktaufnahmen 14 (siehe Fig. 3) der Kontaktplatte 12 in Form von metallisierten Löchern eingesteckt und verlötet, sodass eine feste mechanische und elektrische Verbindung zwischen dem Plattenelement 6 und der Kontaktplatte 12 zustande kommt. Die Kontaktplatte 12 wiederum ist über mehrere Datenleitungen 16, 18 sowie Stromversorgungsleitungen 20 mit einer Kommunikationseinheit 22 verbunden, wobei die Datenleitungen 16, 18 und Stromversorgungsleitungen 20 in eine Folie 24 (siehe Fig. 3) in Form eines Flachbandkabels eingebunden sind.

In der Kontaktplatte 12 sind die Datenleitungen 16, 18 und weitere Datenleitungen 16, 18 so verlegt, dass eine funktionsbezogene Kommunikation der Funktionsgruppen 4 untereinander ermöglicht wird. So sind als Highspeedbusse ausgeführte Datenleitungen 18, die Fig. 1 lang gestrichelt angedeutet sind, zwischen den Funktionsgruppen 4 in der Art angeordnet, dass jede der Funktionsgruppen 4 direkt oder über eine weitere Funktionsgruppe 4 mit allen Funktionsgruppen 4 über eine solche Datenleitung verbunden ist. Eine weitere solche Datenleitung 18 ist über die Kommunikationseinheit 22 nach außen, also nach außerhalb der elektronischen Baugruppe 2, geführt und mündet hierzu in eine Schnittstelle 26, beispielsweise in Form eines Steckers, zur Verbindung mit einem externen Gerät, z. B. einer Steuereinheit oder einer Einheit mit Aktuatoren zur Betätigung mechanischer Gegenstände. Über weitere Datenleitungen 16, die in Fig. 1 kürzer gestrichelt angedeutet sind, kommunizieren die Funktionsgruppen 4 über die Schnittstelle 26 und eine weitere Schnittstelle 28 mit der Außenwelt, z. B. weiteren Funktionsgruppen, Sensoren oder dergleichen, die hierfür an die Schnittstellen 26, 28 signaltechnisch angeschlossen werden.

Über eine Stromversorgungsleitung 20 kann die Kommunikationseinheit 22 von Extern über eine Spannung zur Stromversorgung, insbesondere 5 V, 12 V oder 28 V versorgt werden, die einer Stromversorgungseinheit 30 zugeführt werden. In dieser wird die Spannung auf eine niedrigere Spannung herunter transformiert, beispielsweise 3,3 V und über die weiteren Stromversorgungsleitungen 20 an die Funktionsgruppen 4 weitergegeben. Diese verfügen jeweils ebenfalls über eine Stromversorgungseinheit, in Fig. 1 als Baustein 8 angegeben, zur weiteren Transformierung in eine oder mehrere Arbeitsspannungen der Bausteine 8 der Funktionsgruppen 4, beispielsweise 1,0 V, 1,8 V und 2,5 V.

Die Kontaktplatte 12 und die Kommunikationseinheit 22- übernehmen in ihren Funktionen die Aufgaben einer sogenannten Backplane, die mehrere Funktionseinheiten miteinander verbindet. Bei dem in Fig. 1 dargestellten Ausführungsbeispiel ist diese an sich üblicherweise einheitliche Backplane in zwei Einheiten unterteilt, nämlich die passive Kontaktplatte 12, die also keinerlei elektronische Bausteine trägt, und die aktive Kommunikationseinheit 22, die als Kommunikationsschnittstelle für die Funktionsgruppen 4 bzw. deren Bausteine 8 nach extern dient. Hierzu trägt die Kommunikationseinheit 22 Bauelemente 32, die zur Anpassung der Kommunikation der Bausteine 8 der Funktionsgruppen 4 an eine nach extern durchzuführende Kommunikation vorbereitet sind. So wird durch die Bauelemente 32 beispielsweise ein Kommunikationsprotokoll und/oder eine Amplitude von Kommunikationssignalen von einer internen Kommunikation an eine externe Kommunikation und andersherum angepasst, sodass eine Kommunikationsanpassung der einzelnen Funktionsgruppen 4 entfallen kann. Unabhängig von deren durch die Buchstaben A bis E angedeuteten Aufgaben können diese also gleich ausgeführt sein, da die mit den Aufgaben verbundenen Kommunikationseigenschaften nach außen durch entsprechende Bauelemente 32 der Kommunikationseinheit 22 ausgeführt werden.

Anhand des in Fig. 1 darstellten Ausführungsbeispiels kann dargestellt werden, wie mehrere elektronische Baugruppen, die analog zur Baugruppe 2 ausgeführt sind, für verschiedene Aufgaben effizient hergestellt werden können. So kann neben der in Fig. 1 dargestellten elektronischen Baugruppe 2 eine weitere Baugruppe 2 gedacht werden, die für eine andere Steuerungsaufgabe, beispielsweise eines anderen Flugkörpers oder eines anderen Automatisierungsgeräts, vorbereitet ist. Beide elektronischen Baugruppen 2 umfassen jeweils eine Anzahl von Funktionsgruppen 4, wobei die Anzahlen nicht gleich sein müssen. Die Funktionsgruppen 4 sind jeweils in eine Kontaktplatte 12 eingesteckt oder darin eingelötet und entsprechend der Darstellung in Fig. 1 mit der Kommunikationseinheit 22 verbunden.

Entsprechend der Aufgaben sind die zentralen Prozessoren der Funktionsgruppen 4 programmiert. Ansonsten können sämtliche Funktionsgruppen 4 beider Baugruppen 2 identisch ausgeführt sein. Bei ähnlichen Aufgaben können auch die beiden Kontaktplatten 12 der beiden Baugruppen 2 gleich ausgeführt sein, wobei nur die Kommunikationseinheit 22 an die entsprechenden Steuergeräte, Sensoren oder dergleichen angepasst ist. Hierzu können die beiden Kommunikationseinheiten 22 unterschiedliche Bauelemente 32 tragen und unterschiedlich verdrahtet sein, also z.B. unterschiedliche Leitungsausgänge an den Schnittstellen 26, 28 aufweisen. Bei sehr unterschiedlichen Aufgaben der beiden Baugruppen 2 können auch die Kontaktplatten 12 entsprechend an die Aufgaben angepasst sein, sodass die Verdrahtung, also die Leitungsführungen der Leitungen 16, 18 und gegebenenfalls auch der Stromversorgungsleitungen 20, anders und auf die Aufgaben optimiert ist. Durch diesen modularen Aufbau können für beide Baugruppen 2 stets die gleichen Funktionsgruppen 4 und gegebenenfalls sogar die gleichen Kontaktplatten 12 verwendet werden. Anpassungen der elektronischen Baugruppen 2 an verschiedene Aufgaben kann daher durch einfache Fertigungsänderungen der Kommunikationseinheit 22 und gegebenenfalls der Kontaktplatte 12 erreicht werden. Eine Konfiguration der Funktionsgruppen 4 und eine Anpassung der Backplane an diese Konfigurationen ist nicht mehr notwendig.

Eine weitere Aufgabe, die der Kommunikationseinheit 22 zugeordnet werden kann, ist eine Einschaltsequenzierung der einzelnen Funktionsgruppen 4. Um eine Spannungsquelle nicht zu überlasten, ist es vorteilhaft, wenn die einzelnen Funktionsgruppen 4 bei einer Initialisierung der Baugruppe 2 nicht zeitgleich starten, da in einem solchen Fall viele Bausteine 8 einen hohen Stromverbrauch aufweisen, die hohe Anforderungen an die Stromversorgung stellt. War es bisher üblich, dass eine erste Funktionsgruppe 4 als erste einschaltet, dann ein Einschaltsignal an eine nächste Funktionsgruppe 4 gibt, die wiederum das Einschalten einer weiteren Funktionsgruppe 4 triggert, kann eine solche Einschaltsequenzierung nun durch ein Bauelement 32 der Kommunikationseinheit 22 durchgeführt werden. Auch hierdurch entfällt eine spezielle Anpassung der Funktionsgruppen 4 an eine gewünschte Einschaltsequenzierung, da diese von der Aufgabe der Einschaltsequenzierung völlig befreit sind. Entsprechende Signale können von einem Bauelement 32 über eine Datenleitung 16 an die Funktionsgruppen 4 gegeben werden, die auf Kommando der Kommunikationseinheit 22 einschalten. Durch diese an die Modularität der Baugruppe 2 angepasste Aufgabenverteilung kann die Standardisierbarkeit der Funktionsgruppen 4 weiter erhöht werden.

Bei elektronischen Baugruppen 2 kommt einer Fehlererkennung und Fehlerbeseitigung eine hohe Bedeutung zu. Zur einfachen und zentralisierten Bewältigung dieser Aufgabe trägt die Kommunikationseinheit 22 ein Bauelement 34, das als Testschnittstelle konfiguriert ist. Durch diese Testschnittstelle kann auf jede der Funktionsgruppen 4 mit Testsignalen zugegriffen und entsprechende Ausgangssignale zur Überprüfung der Funktion der Funktionsgruppen 4 an der Schnittstelle 26 abgegriffen werden. Eine entsprechende Vorbereitung an den einzelnen Funktionsgruppen 4 kann entfallen, sodass diese - unabhängig von ihrer durch Programmierung aufgeprägten Funktionen - auf die korrekte Bearbeitung ihrer Aufgaben getestet werden können. Besondere Anforderungen an die Hardware oder Verdrahtungen durch solche Tests können in der Kommunikationseinheit 22 implementiert werden. Eine in Bezug auf die unterschiedlichen Aufgaben der Funktionsgruppen 4 notwendige Anpassung betrifft daher wiederum nur die Kommunikationseinheit 22, sodass eine hohe Standardisierung der übrigen Baueinheiten der Baugruppe 2 erreichbar ist.

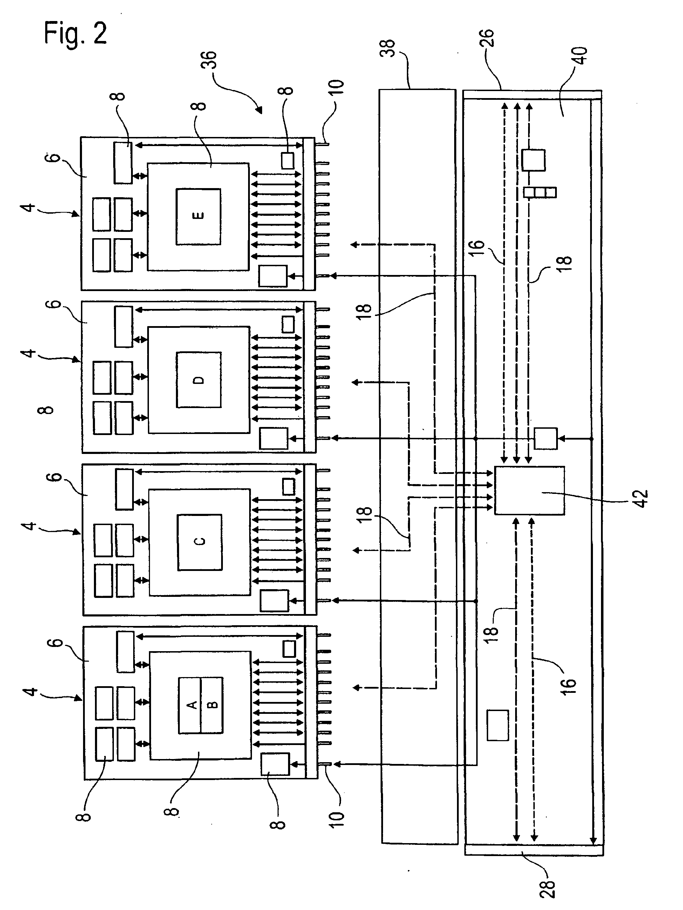

Ein weiteres Ausführungsbeispiel einer elektronischen Baugruppe 36 ist in Fig. 2 dargestellt. Die nachfolgende Beschreibung beschränkt sich im Wesentlichen auf die Unterschiede zum Ausführungsbeispiel aus Fig. 1, auf das bezüglich gleichbleibender Merkmale und Funktionen verwiesen wird. Im Wesentlichen gleichbleibende Bauteile sind grundsätzlich mit den gleichen Bezugszeichen beziffert und nicht erwähnte Merkmale sind in den folgenden Ausführungsbeispielen übernommen, ohne dass sie erneut beschrieben sind.

Wiederum ist die elektronische Baugruppe 36 mit den identischen Funktionsgruppen 4 und einer Kontaktplatte 38 versehen, die mit einer Kommunikationseinheit 40 verbunden ist. Die Kommunikationseinheit 40 trägt einen Router 42, der über Datenleitungen 18, die als Highspeedbus ausgeführt sind, mit einzelnen Funktionsgruppen 4 verbunden ist. Die Busverbindung vom Router 42 zu den Funktionsgruppen 4 ist durch die von den Kontaktstellen 10 entfernter endenden Pfeilen der Datenleitungen 18 nur angedeutet und in Fig. 2 den Kontaktstellen 10 nicht konkret zugewiesen. Über Busverbindungen ist der Router 42 auch mit den beiden Schnittstellen 26, 28 verbunden, ebenfalls nur schematisch dargestellt. Die gesamte Kommunikation zwischen den Funktionsgruppen 4 verläuft über den Router 42, der hierdurch über sämtliche Datenaustauschschritte der Funktionsgruppen 4 untereinander und nach und von außen informiert ist.

Der Router 42 bildet somit eine Kommunikationsdrehscheibe der elektronischen Baugruppe 36, die nicht blockierend ausgeführt ist, also in ihrer Kommunikationsdatenrate zulässt, dass sämtliche mit ihr verbundenen Bausteine 8 zeitgleich mit der ihnen zugewiesenen Datenrate kommunizieren. Der Router 42 ist dazu vorbereitet, die gesamten oder auch nur festgelegte einzelne Bereiche der Kommunikation der Funktionsgruppen 4 untereinander und insbesondere auch der Funktionsgruppen 4 nach außen zu protokollieren. Um eine Abfrage von Kommunikationsdaten von außen zu ermöglichen, ist der Router 42 mit einer Datenschnittstelle nach außen ausgeführt.

Auf diese Weise können von außen Daten zu Kommunikationsvorgängen der Funktionsgruppen 4 abgerufen werden und beispielsweise für einen Funktionstest der Funktionsgruppen 4 oder eine Fehlerbehebung (Debugging) verwendet werden. Zweckmäßig ist es, diese Kommunikationsdaten oder Teile davon zu visualisieren, also auf einen Bildschirm z. B. grafisch darzustellen, sodass Kommunikationsfehler schnell gefunden und hieraus auf Funktionsfehler der Funktionsgruppen 4 geschlossen werden können. Es ist auch möglich, dass bereits der Router 42 dazu vorbereitet ist, beispielsweise durch eine entsprechende Programmierung, Kommunikationsdaten mit Solldaten zur Kommunikation zu vergleichen und aus diesem Vergleich resultierende Daten nach außen zu geben, sodass eine Auswertung von außen vereinfacht wird. Auf diese Weise kann eine zielgerichtete Überprüfung der Funktionsgruppen 4 bereits bei der Herstellung der elektronischen Baugruppe 36 zielgerichtet implementiert werden.

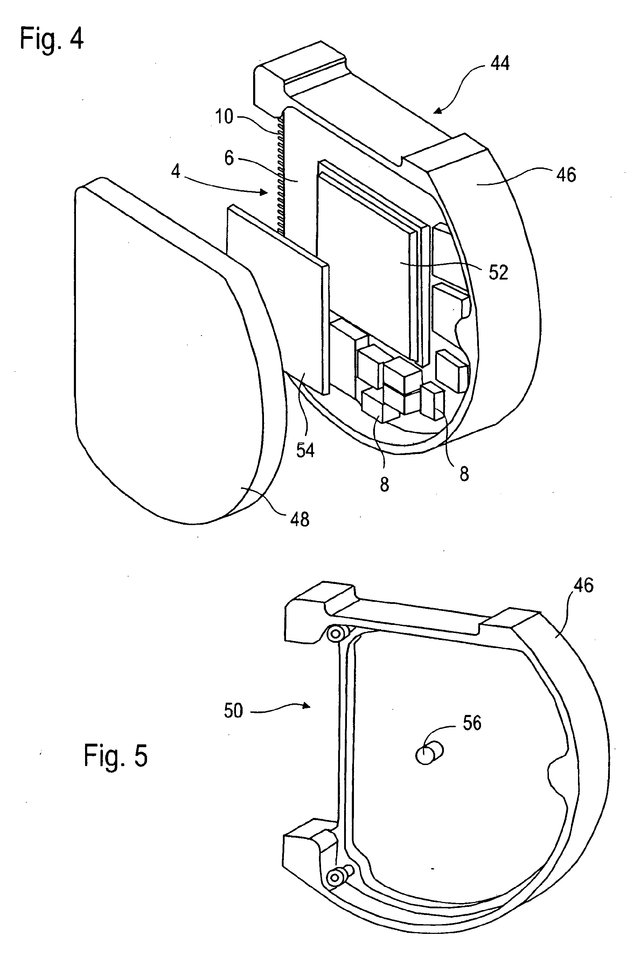

In den Fig. 3 bis 5 sind konkrete geometrische Realisierungen der elektronischen Baugruppe 2 dargestellt, wobei auch die Baugruppe 36 entsprechend ausgeführt sein kann. Wie aus Fig. 4 zu sehen ist, ist eine Funktionsgruppe 4 - und dies gilt für alle Funktionsgruppen 4 - in einem Gehäuse 44 gelagert, das aus einer Gehäusebasis 46 und einem mit der Gehäusebasis 46 zu verschraubenden Deckel 48 besteht. Durch eine seitliche Öffnung 50 (siehe Fig. 5) ragen die Kontaktstellen 10 des Plattenelements 6 durch das Gehäuse 44 nach außen. Auch das Plattenelement 6 ist in der Gehäusebasis 46 verschraubt.

Zur Kühlung des zentralen Prozessors 52 ist zwischen diesem und dem Gehäusedeckel 48 eine thermische Brücke 54 in Form eines Gelpads angeordnet, das bei verschlossenem Deckel 48 sowohl den Prozessor 52 als auch den Deckel 48 unmittelbar kontaktiert. Auf seiner anderen Seite ist der Prozessor 52 ebenfalls mit einer thermischen Senke verbunden, die durch eine Ausformung 56 - gegebenenfalls ebenfalls mit einem zusätzlichen Gelpad - realisiert ist, die das Plattenelement 6 auf seiner nicht dargestellten Rückseite unmittelbar oder über das Gelpad thermisch kontaktiert. Hierdurch wird das Plattenelement 6 in einem inneren Bereich, der vom Randbereich des Plattenelements 6 beabstandet ist, thermisch kontaktiert, sodass über die Ausformung 56 vom Prozessor 52 abgegebene Wärme direkt in das Gehäuse 44 geführt wird. Außerdem ist das Plattenelement 6 in seinem inneren Bereich mechanisch gehalten und hierdurch besonders geschützt gegen starke Vibrationen.

Die vier Gehäuse 44 der vier Funktionsgruppen 4 sind im fertigen Zustand der Baugruppe 2 miteinander verschraubt und bilden hierdurch einen mechanisch sehr stabilen Verbund. Dieser Verbund ist zusätzlich mit der Kontaktplatte 12 verschraubt, wie anhand angedeuteter Schrauben 58 dargestellt ist. Auch jede andere mechanische Befestigung durch ein anderes Befestigungsmittel ist denkbar.

Um diesen festen Verbund herumgelegt sind die Kontaktplatte 12, die leitungstragende Folie 24 und die Kommunikationseinheit 22, die zusammen die Funktionsgruppen 4 von zwei Seiten umgreifen. Hierdurch ist die Baugruppe 2 sehr kompakt ausgeführt. Mittels einer Verschraubung oder einer anderen geeigneten Befestigung ist die Kommunikationseinheit 22 außerdem mit den Funktionsgruppen 4 - im gezeigten konkreten Ausführungsbeispiel mit dem Gehäuse 44 zumindest einer Funktionsgruppe 4 - verbunden, sodass ein mechanisch besonders stabiler Verbund entsteht. Anhand einer äußeren Stützstruktur 60 ist die Baugruppe 2 mechanisch stabil in einer Umgebung, beispielsweise einem Lenkflugkörper, einbindbar. Die signaltechnische Verbindung nach außen geschieht hierbei über die beiden Schnittstellen 26, 28, die beispielsweise als Stecker ausgeführt sind und mit einem Sucher bzw. einem Lenkteil verbunden werden können. Beide Schnittstellen 26, 28 sind, analog zur Folie 24, über flexible Verbinder 62 mit der Kommunikationseinheit 22 verbunden, sodass die Kommunikationseinheit 22 auf drei Seiten (eine Seite ist nicht sichtbar, jedoch ebenso ausgeführt) in der Bauweise fest-flexibel-fest signaltechnisch kontaktiert ist.

Um eine besonders kompakte und Ressourcen sparende Geometrie der Baugruppe 2 zu erreichen, ist die Kommunikationseinheit 22 in einer bestimmten Geometrie zur Kontaktplatte 12 angeordnet. Bei dieser Geometrie schneiden die verlängert gedachten Plattenelemente 6 die Kommunikationseinheit 22. Bei einer kleineren Kommunikationseinheit 22 ist es ausreichend, wenn zumindest eines der Plattenelemente 6 in einer gedanklich verlängerten Form die Kommunikationseinheit 22 schneidet. Allgemein gesprochen ist die Kommunikationseinheit 22 über mehrere Datenleitungen 16, 18 mit der Kontaktplatte 12 verbunden, wobei die Datenleitungen 16, 18 auf derjenigen Seite 64 der Kontaktplatte 12 mit dieser verbunden sind, auf die die Reihen 66 der Kontaktstellen 10 der Plattenelemente 6 weisen, wie in Fig. 3 dargestellt ist.

Bei dem gezeigten Ausführungsbeispiel bilden Kontaktplatte 12 und Kommunikationseinheit 22 einen rechten Winkel zueinander, wobei andere Winkel ebenfalls denkbar sind. Eine Parallelität von Plattenelementen 6 und der Kommunikationseinheit 22 ist insbesondere nicht vorgesehen. Durch diese Geometrie können die Datenleitungen 16, 18 von den Funktionsgruppen 4 zur Kommunikationseinheit 22 geführt werden, ohne dass sie eine von den Reihen 66 jeweils gebildet gedachte Linie kreuzen müssen. Eine gedachte Linie in Verlängerung der Reihen 66, die jeweils parallel zu den ihm zugeordneten Plattenelement 6 sind, weist daher direkt auf die Seite 64 und auf die Kommunikationseinheit 22 oder eine entsprechende Kontaktierung von einer Datenleitung 16, 18 von der Kontaktplatte 12 zur Kommunikationseinheit 22.

### Bezugszeichenliste

- 2: Baugruppe
- 4: Funktionsgruppe
- 6: Plattenelement
- 8: Baustein
- 10: Kontaktstelle
- 12: Kontaktplatte
- 14: Kontaktaufnahme
- 16: Datenleitung
- 18: Datenleitung
- 20: Stromversorgungsleitung
- 22: Kommunikationseinheit
- 24: Folie
- 26: Schnittstelle
- 28: Schnittstelle
- 30: Stromversorgungseinheit
- 32: Bauelement
- 34: Bauelement
- 36: Baugruppe
- 38: Kontaktplatte
- 40: Kommunikationseinheit
- 42: Router
- 44: Gehäuse
- 46: Gehäusebasis
- 48: Deckel
- 50: Öffnung
- 52: Prozessor
- 54: Brücke
- 56: Ausformung
- 58: Schraube
- 60: Stützstruktur
- 62: Verbinder
- 64: Seite
- 66: Reihe

## Patentansprüche

1. Steuereinheit (2, 36) zur eigenständigen Steuerung eines Flugkörpers mit
a) mehreren Funktionseinheiten (4), die jeweils ein mit elektronischen Bausteinen (8) bestücktes Plattenelement (6) umfassen, wobei die Plattenelemente (6) über eine Kontaktplatte (12, 38) signaltechnisch miteinander verbunden sind, und
b) einer mit der Kontaktplatte (12, 38) unmittelbar durch Datenleitungen (16, 18) verbundenen Kommunikationseinheit (22, 40), die mit elektronischen Bauelementen (32) derart bestückt ist, dass sie als Kommunikationsschnittstelle für Bausteine (8) der Plattenelemente (6) dient,
wobei
c) zumindest einzelne der Funktionseinheiten mit Systemen außerhalb der Steuereinheit (2, 36) kommunizieren, um eine Steuerung zu bewirken oder Sensor- oder Steuersignale empfangen zu können, und
d) die Kommunikationseinheit (22, 40) so ausgeführt ist, dass sie eine informationsverbindende Kommunikationsschnittstelle zwischen zumindest einem internen Kommunikationsmodus einer Funktionseinheit (4) mit einem davon unterschiedlichen externen Kommunikationsmodus einer Einheit außerhalb der Steuereinheit (2, 36) bildet.

2. Steuereinheit (2, 36) nach Anspruch 1,
wobei die Kontaktplatte (12, 38) passiv ist.

3. Steuereinheit (2, 36) nach Anspruch 1 oder 2,
wobei die Funktionseinheiten (4) in ihrer Hardware alle identisch ausgeführt sind und mit einem identischen Prozessor (52) ausgestattet sind, die durch entsprechende Datenverarbeitungsprogramme unterschiedliche Aufgaben bearbeiten.

4. Steuereinheit (2, 36) nach einem der vorhergehenden Ansprüche,
wobei die Kontaktplatte (12, 38) eine an einzelne Aufgaben der Funktionseinheiten (4) angepasste aufgabenspezifische Leitungsführung aufweist, die von einer zu einer zweiten Funktionseinheit (4) anders ausgeführt ist, als von der zweiten zu einer dritten Funktionseinheit (4).

5. Steuereinheit (2, 36) nach einem der vorhergehenden Ansprüche,
wobei eines der elektronischen Bauelemente (32) ein Router (42) ist, der zur Protokollierung von Kommunikation zwischen elektronischen Bausteinen (8) der Plattenelemente (6) ausgeführt ist.

6. Steuereinheit (2, 36) nach einem der vorhergehenden Ansprüche,
wobei die Kommunikationseinheit (22) eine Stromversorgung für die Funktionseinheiten (4) aufweist, die eine Zwischenspannung herstellt, die zwischen einer von außen zugeführten Spannung und einer von Bausteinen (8) der Funktionseinheiten (4) benötigten Spannung liegt.

7. Steuereinheit (2, 36) nach einem der vorhergehenden Ansprüche,
wobei die Kommunikationseinheit (22) zur Steuerung einer Einschaltsequenzierung der einzelnen Funktionseinheiten (4) vorbereitet ist.

8. Steuereinheit (2, 36) nach einem der vorhergehenden Ansprüche,
wobei die Kommunikationseinheit (22) mit einer Test-Schnittstelle (34) zur Funktionsprüfung der einzelnen Funktionseinheiten (4) versehen ist.

9. Verfahren zum Betrieb einer Steuereinheit (2, 36) zur eigenständigen Steuerung eines Flugkörpers nach einem der Ansprüche 1 bis 7,
wobei eines der elektronischen Bauelemente (32) ein Router (42) ist, der eine Kommunikation von zumindest einer Funktionseinheit (4) protokolliert und dass Kommunikationsdaten mit Solldaten zur Kommunikation verglichen werden und Kommunikationsdaten zum Anzeigen von Kommunikationsprozessen visualisiert werden.

## Claims

1. Control unit (2, 36) for the autonomous control of a missile having
a) a plurality of functional units (4) each comprising a board element (6) populated with electronic modules (8), wherein the board elements (6) are connected to one another in terms of signaling via a contact board (12, 38), and
b) a communication unit (22, 40) connected to the contact board (12, 38) directly by data lines (16, 18), said communication unit being populated with electronic components (32) in such a way that it serves as a communication interface for modules (8) of the board elements (6),
wherein
c) at least individual functional units communicate with systems outside the control unit (2, 36) in order to bring about control or to be able to receive sensor or control signals, and
d) the communication unit (22, 40) is embodied such that it forms an information-linking communication interface between at least one internal communication mode of a functional unit (4) and an external communication mode - different therefrom - of a unit outside the control unit (2, 36).

2. Control unit (2, 36) according to Claim 1,
wherein the contact board (12, 38) is passive.

3. Control unit (2, 36) according to Claim 1 or 2,
wherein the functional units (4) are all embodied identically in terms of their hardware and are equipped with an identical processor (52), which process different tasks by virtue of corresponding data processing programs.

4. Control unit (2, 36) according to any of the preceding claims,
wherein the contact board (12, 38) has a task-specific line routing which is adapted to individual tasks of the functional units (4) and which is embodied differently from one to a second functional unit (4) than from the second to a third functional unit (4).

5. Control unit (2, 36) according to any of the preceding claims,
wherein one of the electronic components (32) is a router (42) embodied for logging communication between electronic modules (8) of the board elements (6).

6. Control unit (2, 36) according to any of the preceding claims,
wherein the communication unit (22) has a power supply for the functional units (4), which produces an intermediate voltage lying between a voltage fed in externally and a voltage required by modules (8) of the functional units (4).

7. Control unit (2, 36) according to any of the preceding claims,
wherein the communication unit (22) is prepared for controlling a switch-on sequencing of the individual functional units (4).

8. Control unit (2, 36) according to any of the preceding claims,
wherein the communication unit (22) is provided with a test interface (34) for functionally testing the individual functional units (4).

9. Method for operating a control unit (2, 36) for the autonomous control of a missile according to any of Claims 1 to 7,
wherein one of the electronic components (32) is a router (42), which logs a communication of at least one functional unit (4), and in that communication data are compared with desired data for communication and communication data are visualized for displaying communication processes.

## Revendications

1. Unité de commande (2, 36) permettant la commande autonome d'un aéronef et présentant
a) plusieurs unités fonctionnelles (4) qui comportent chacune un élément de carte de circuit (6) équipé de modules électroniques (8), les éléments (6) de carte de circuit étant raccordés les uns aux autres par l'intermédiaire d'une carte de contact (12, 38) de manière à pouvoir échanger des signaux, et
b) une unité de communication (22, 40) raccordée directement à la carte de contact (12, 38) par des conducteurs (16, 18) de données, l'unité de communication étant équipée de composants électroniques (32) de manière à servir d'interface de communication pour les modules (8) des éléments (6) de carte de circuit,
c) au moins certaines des unités fonctionnelles communiquant avec des systèmes situés à l'extérieur de l'unité de commande (2, 36) pour exercer une commande ou pouvoir recevoir des signaux de capteur ou de commande et
d) l'unité de communication (22, 40) étant réalisée de manière à former une interface de communication reliant des informations en au moins un mode interne de communication d'une unité fonctionnelle (4) et un mode externe de communication, différent du premier, d'une unité située à l'extérieur de l'unité de commande (2, 36).

2. Unité de commande (2, 36) selon la revendication 1, dans laquelle la carte de contact (12, 38) est passive.

3. Unité de commande (2, 36) selon les revendications 1 ou 2, dans laquelle les unités fonctionnelles (4) présentent le même matériel électronique et sont équipées d'un même processeur (52), ces matériels exécutant des tâches différents grâce à des programmes appropriés de traitement de données.

4. Unité de commande (2, 36) selon l'une des revendications précédentes, dans laquelle la carte de contact (12, 38) présente des conducteurs spécifiques adaptés aux différentes tâches des unités fonctionnelles (4) réalisées différemment entre une unité fonctionnelle (4) et une deuxième et entre une deuxième unité fonctionnelle (4) et une troisième.

5. Unité de commande (2, 36) selon l'une des revendications précédentes, dans laquelle l'un des composants électroniques (32) est un routeur (42) configuré pour protocoler la communication entre les modules électroniques (8) des éléments (6) de carte de circuit.

6. Unité de commande (2, 36) selon l'une des revendications précédentes, dans laquelle l'unité de communication (22) présente une alimentation en courant des unités fonctionnelles (4) qui définit une tension intermédiaire située entre la tension apportée de l'extérieur et la tension nécessaire au module (8) des unités fonctionnelles (4).

7. Unité de commande (2, 36) selon l'une des revendications précédentes, dans laquelle l'unité de communication (22) est préparée pour commander un séquençage de branchement des différentes unités fonctionnelles (4).

8. Unité de commande (2, 36) selon l'une des revendications précédentes, dans laquelle l'unité de communication (22) est dotée d'une interface de test (34) qui permet de vérifier le bon fonctionnement des différentes unités fonctionnels (4).

9. Procédé de conduite d'une unité de commande (2, 36) qui permet la commande autonome d'un aéronef selon l'une des revendications 1 à 7,
dans lequel l'un des composants électroniques (32) est un routeur (42) qui protocole la communication d'au moins une unité fonctionnelle (4), les données de communication étant comparées en vue de la communication avec des données de consigne et les données de communication étant visualisées pour afficher les processus de communication.
